Europäisches Patentamt

European Patent Office

Office européen des brevets

(11) Publication number: **0 192 874**
**B1**

(12) **EUROPEAN PATENT SPECIFICATION**

(45) Date of publication of patent specification: **14.03.90**

(51) Int. Cl.⁵: **C 23 C 10/28,** C 23 C 12/02, C 23 C 8/10, C 23 C 26/00, H 01 L 21/263

(21) Application number: **85306679.3**

(22) Date of filing: **19.09.85**

(54) Method for injecting exotic atoms into a solid material with electron beams.

(30) Priority: **27.02.85 JP 36614/85**

(43) Date of publication of application:
**03.09.86 Bulletin 86/36**

(45) Publication of the grant of the patent:
**14.03.90 Bulletin 90/11**

(84) Designated Contracting States:
**DE FR GB**

(56) References cited:
**EP-A-0 046 914**
**EP-A-0 098 453**
**EP-A-0 181 073**
**EP-A-0 193 674**
**EP-A-2 073 254**
**GB-A-1 194 049**
**GB-A-2 031 955**
**GB-A-2 125 442**
**US-A-4 122 240**

(73) Proprietor: **OSAKA UNIVERSITY**
**1-1 Yamadaoka**
**Suita City Osaka-Fu (JP)**

(72) Inventor: **Fujita, Hiroshi**
**12-22, Yamatedai 5-Chome**
**Ibaraki City Osaka-fu (JP)**
Inventor: **Sumida, Naoto**
**3-30-201, Wakamiyadai 2-Chome**
**Shimamoto-Cho Mishima-Gun Osaka-fu (JP)**

(74) Representative: **Rooney, Paul Blaise et al**
**D.Young & Co. 10 Staple Inn**
**London WC1V 7RD (GB)**

Courier Press, Leamington Spa, England.

**Description**

This invention relates to a method of injecting foreign atoms into a solid substrate using an electron beam for materials engineering.

In the field of materials engineering, composite materials are continually being developed in the search for new materials having new functions and thus a high value.

Conventional methods for producing composite materials may be classified roughly as follows:

(I) The composite materials are produced by joining independent materials by any method such as by welding, electrodeposition, thermal diffusion, adhesives or combinations thereof.

(II) The composite materials are produced by heat-treating or mechanically treating alloys of two phases or multiple phases.

(III) Ions are implanted into a material with ion beams.

(IV) Foreign atoms added to the surface of materials are injected into the materials by beam-annealing techniques involving surface melting and thermal diffusion using electron beams or laser beams as a source of heat.

In the known method (I), it is generally difficult to obtain a properly joined interface. As a result, the charactersitic properties at or of the joined interface are difficult to control. Therefore, the production of composite materials having a superfine structure of about 1—10 nmφ in size is impossible. These disadvantages are inevitable.

In the known method (II), as alloy phases which are stable or stable to some extent in an equilibrium state are used, it is difficult to develop materials having improved functions. Furthermore, it is difficult to control as desired the dimensions, number of and conditions of distribution of the deposit phases.

In the known method (III), there are disadvantages inherent with ion beams, namely shallow implantation depth of the foreign atoms, great damage to the materials irradiated with ion beams, and difficulty of control of the dimensions of the mixed phase regions.

In the known method (IV), there are also disadvantages, such as difficulty in controlling the dimensions of a mixed phase zone formed and its concentration as well as producing great heat distortion of the surface. Such a method (IV) involving surface melting and thermal diffusion is known from US—A—4122240 and EP—A—0046914.

US—A—4122240 discloses the application to a substrate of a layer of material which forms a eutectic with the substrate, the melting of the layer into the substrate by laser or electron beam and the subsequent quenching of the molten layer to form a surface layer of substantially eutectic composition.

EP—A—0046914 discloses the formation in a semi conductor material of a disturbed surface layer by laser, the application to this disturbed surface layer of a metal layer and the alloying of this metal layer into the disturbed surface layer by melting the metal layer into the disturbed surface layer by means of heat supplied by a furnace, laser or electron beam radiation.

According to the present invention there is provided a method of injecting foreign atoms into a solid substrate using an electron beam, said method comprising providing a layered structure made up of the solid substrate and at least one film layer adhered to one surface of said solid substrate, which film layer contains at least one type of foreign atom to be injected, and irradiating a predetermined region of the structure with an electron beam directed towards the film layer to cause aimed displacment of said at least one type of foreign atom from the film layer into the solid substrate, without thermal diffusion, to provide a zone of mixed atoms in the irradiated region, said zone of mixed atoms having a concentration of said at least one type of displaced foreign atom which ranges up to supersaturation and which is independent of the thermal equilibrium state, and said electron beam having an energy which is greater than the threshold energy for the at least one type of displaced foreign atom, this method not being a method of amorphizing a solid crystalline material by irradiation with an electron beam, characterised by attaching to one surface of a crystalline solid material to be rendered amorphous, a film layer containing at least one type of foreign atom to be injected into the crystalline solid material so that the material and attached layer form a layered structure, and irradiating the structure with an electron beam directed towards the film layer, at an accelerated voltage of at least 200 kV, with an electron beam intensity of at least $1 \times 10^{18}$ e/cm$^2$-sec and at a temperature of not more than 100°C, thereby to displace foreign atoms from the layer and inject the displaced foreign atoms into the irradiated regions of the crystalline solid material and render the crystalline material amorphous.

The at least one film layer which contains at least one type of foreign atom to be injected into the solid substrate may be attached to the solid material substrate by vacuum deposition, sputtering, or beam annealing electrodeposition. When the so formed at least two layer structure is irradiated towards the film layer with electron beam radiation having an energy greater than the threshold energy for displacing the foreign atoms from the film layer, these atoms are displaced into the solid material of the substrate. This movement does not result in thermal diffusion. As a result, the foreign atoms contained in the film layer are injected into the solid material of the substrate forming a zone of mixed atoms near the interface and preferably limited to the small region of electron beam irradiation.

Thus the method of the invention allows the production of a composite material, which forms a zone of mixed atoms having a desired combination, composition, dimensions and the distribution of the injected foreign atoms, by controlling the mixed zone which consists of atoms of the solid substrate material and the injected atoms in the region of the film layer irradiated by electron beam.

Using this method for producing the composite material, many disadvantages of the above conventional methods are avoidable. Furthermore, composite materials having new functions can be efficiently produced by the method of the invention using electron beam irradiation.

For a better understanding of the present invention, and to show how the same may be carried into effect, reference will now be made by way of example to the accompanying drawings, in which:—

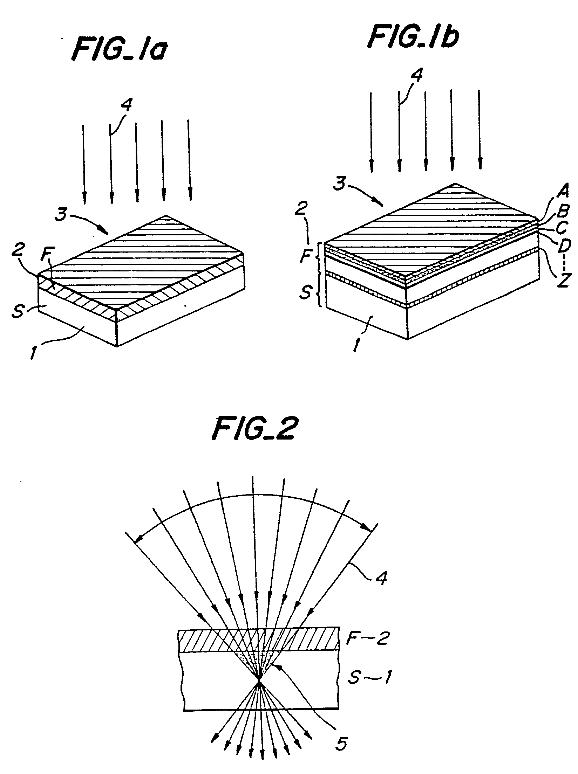

Figures 1a and 1b are schematic perspective views of examples of the method of this invention, with Figure 1a showing the irradiation of a two layer material from the film layer side with electrons of high energy, in which the material consists of a solid substrate (S) and a film layer (F) containing foreign atom element components (A, B, C...) to be injected into the material of the solid substrate, and with Figure 1b showing the irradiation of a material in a manner similar to Figure 1a but in which the material consists of a solid substrate (S) and several film layers (F), with each film layer containing at least one type of foreign atom element components (A, B, C, ...), and

Figure 2 is a schematic sectional view of material being irradiated according to the method of the invention showing a way of controlling the distribution and concentration of injected foreign atoms by control of intensity of the electron beams.

In Figures 1a and 1b, a film layer (F) 2 containing several types of foreign atom element components (A, B, C, ...) which are to be injected into the material of a solid substrate (S) 1, is attached to the solid substrate (S) 1 by vacuum deposition, sputtering, beam annealing, electro-deposition, or the like. The layered structure so obtained is a two or more layer structure 3 (F-S) in Figures 1a and 1b.

When electron beams 4 having sufficient energy are directed on the F-S material (the two or more layer structure 3) against the film layer 2 at given conditions of intensity, angle of incidence and angle of reflection of the electron beams, irradiation temperature and irradiation time, electrons collide with foreign atoms A, B, C, ... in the film layer or film layers (F) to displace the foreign atoms from their positions. As a result, these foreign atoms transfer to the interface of F and S, are ejected from F and injected into the material of the solid substrate (S). Thus, a zone of mixed atoms is produced. The transfer of the foreign atoms does not result in thermal diffusion.

In this example, the electron beams used for the irradiation must have sufficient energy to displace all foreign atoms which are contained in the film layer or film layers (F). However, depending on the kinds of composite materials which are to be produced, when the structure is irradiated with electron beams having high energy which exceeds the threshold energy for displacing the atoms contained in the material of the solid substrate (S), the atoms are diffused by the enhanced irradiation so that a mixed zone is efficiency produced. Furthermore, when load stress is applied to the F-S material of the two or more layer structure during irradiation while the F-S material is heated, an effect similar to that described above is obtained.

The nature, components, form, dimensions, etc. of the mixed atom zone which is formed in the solid substrate (S) can be changed by suitable selecting the energy of the electron beams, intensity, irradiation, temperature and irradiation time.

Furthermore, as shown in Figure 2, the intensity of the electron beams in the solid substrate (S) may be controlled by convergence or divergence of the electron beams, or continuous changes of angles of incidence, whereby the distribution and concentration of the foreign atoms which are injected in the direction of the thickness of an F-S mixed layer 5 may be varied. According to this method, the concentration of the foreign atoms injected as shown in Figure 2 can be controlled in the direction of depth and at the same time the dimensions of the zone can be controlled.

The solid materials which may be treated by the method of this invention are semiconductor materials, ceramic materials, and metal materials.

Thus the method of this invention is applicable to the following products:—

(1) Various electronic materials whose dimensions, concentration, form and depth are controlled by injection of foreign atoms to a depth of several nm.

(2) Various composite materials in which foreign atoms or foreign alloys are controlled to any form, concentration, dimension and depth and are evenly distributed by bonding well with the other materials.

(3) Materials amorphized by injection of a supersaturation of exotic atoms.

(4) New materials having phases which are unexpected from the phase diagrams.

In the method of this invention, foreign atoms are injected into the solid substrate with electron beams having high energy, so that the composite materials so produced may have the following advantages:

(1) The diameter of the electron beams can be easily changed with an electron lens. The size of the diameter can be reduced to about 1 nm. As a result, electronic materials and composite materials having extremely fine structures can be produced.

(2) As the diameter of the electron beams and the irradiation places can be easily controlled with the electronmagnetic field, the form or shape of parts injected with the foreign atoms can be freely changed. Furthermore, various figures containing fine figures of nm in width can be directly drawn satisfactorily.

(3) As the electron beams have a great percentage of transmission, mixed atom zones or layers of about 0.1 mm in thickness can be produced.

(4) As the mixed atom zones or layers can be produced by irradiation in short times, the composite materials can be rapidly obtained.

# EP 0 192 874 B1

(5) By suitably selecting conditions such as the energy of the electron beams, control of irradiation angles, means for reducing the aperture or focus of the beams, or irradiation temperature, the concentration of the foreign atoms injected can be suitably controlled.

(6) When the mixed atom zone or layer and the substrate are connected at the interface between the mixed atom zone or layer and the solid substrate (S), inherent properties of the interface can be controlled.

(7) As the mixed atom zone or layer is produced without using the thermal diffusion, the alloy layer which is absent in the equilibrium state can be obtained.

Examples of conditions of irradiation for the inventive method are shown in the following table. By these conditions, a mixed atom zone or layer consisting of a film layer (F) and a solid substrate (S) can be obtained with the method of the invention.

TABLE

| Material | | Energy of electron beams | Intensity of electron beams | Irradiation temperature | Irradiation time | Produced mixed layer |
|---|---|---|---|---|---|---|
| film (F) | solid (S) | | | | | |
| Pd | Si | 2.4 MeV | $1 \times 10^{20}$ e/cm$^2 \cdot$ sec | 20°C | 30 min | Pd$_2$Si |
| Au | Si | 2.5 MeV | $1 \times 10^{20}$ e/cm$^2 \cdot$ sec | 110°C | 15 min | Amorphous material (easily crystallized by heating) |

Effects of the method of this invention are:

(A) When the method of this invention is used, mixed layers having any thickness to a maximum of several nm can be produced by a combination of this method and other methods. Furthermore, the bond between the film layer and the solid substrate is good.

(B) The diameter of the electron beams can easily be changed with an electron lens. The diameter can be reduced to about 1 nmφ. Hence, composite materials having extremely fine structures of complex material can be directly produced. Furthermore, dimensions, form and distribution of the mixed atom zones or layers can be suitably controlled.

(C) When the electron beams used in the irradiation have a higher energy than the energy which is used for the displacement of the atoms in the solid substrate (S), point defects are introduced by the irradiation into the solid substrate (S). As the point effects enhance the diffusion velocity, the foreign atoms which are injected into the solid substrate can be injected to a greater distance. Accordingly, by the synergic effect of the great penetration of the electron beams and the enhanced diffusion depending on the produced point defects, the thickness of the mixed atom zones or layers can be easily increased to several nm. If the solid substrate (S) is a single crystal, the channelling phenomenon of the electrons having high energy can be used. As a result, the penetration becomes greater so that thick mixed atom zones or layers can be produced. When the material is irradiated under the condition in which stress is applied, the diffusion of the point defects is enhanced or reduced in the specified direction, so that the thickness of the mixed atom zones or layers can be easily controlled.

Reference is made to the present Applicant's copending European application 85 306 678.5 (EP—A—0 193 674) which discloses and claims a method of amorphizing a solid crystalline material by irradiation with an electron beam, characterized by attaching to one surface of a crystalline solid material to be rendered amorphous, a film layer containing at least one type of foreign atom to be injected into the crystalline solid material so that the material and attached layer form a layered structure, and irradiating the structure with an electron beam directed towards the film layer at an accelerated voltage of at least 200 kV, with an electron beam intensity of at least $1 \times 10^{18}$ e/cm$^2$ sec and at a temperature of not more than 100°C, thereby to displace foreign atoms from the layer and inject the displaced foreign atoms into the irradiated regions of the crystalline solid material and render the crystalline material amorphous. Such method of amorphizing a solid crystalline material is disclaimed in the appended Claims.

## Claims

1. A method of injecting foreign atoms into a solid substrate using an electron beam, said method comprising providing a layered structure made up of the solid substrate (S, 1) and at least one film layer (F, 2) adhered to one surface of said solid substrate, which film layer contains at least one type of foreign atom to be injected, and irradiating a predetermined region of the structure with an electron beam (4) directed towards the film layer (F, 2) to cause aimed displacement of said at least one type of foreign atom from the film layer (F, 2) into the solid substrate (S, 1), without thermal diffusion, to provide a zone of mixed atoms in the irradiated region, said zone of mixed atoms having a concentration of said at least one type of displaced

4

foreign atom which ranges up to supersaturation and which is indpendent of the thermal equilibrium state, and said electron beam having an energy which is greater than the threshold energy for at least one type of displaced foreign atom, this method not being a method of amorphizing a solid crystalline material by irradiation with an electron beam, characterised by attaching to one surface of a crystalline solid material to be rendered amorphous, a film layer containing at least one type of foreign atom to be injected into the crystalline solid material so that the material and attached layer form a layered structure, and irradiating the structure with an electron beam directed towards the film layer at an accelerated voltage of at least 200 kV, with an electron beam intensity of at least $1 \times 10^{18}$ e/cm$^2$sec and at a temperature of not more than 100°C, thereby to displace foreign atoms from the layer and inject the displaced foreign atoms into the irradiated regions of the crystalline solid material and render the crystalline material amorphous.

2. A method according to Claim 1, wherein the foreign atoms composing the film layer (F, 2) are PD and the material forming the solid substrate (S, 1) is Si.

3. A method according to Claim 2, wherein the electron beam energy is about 2.4 MeV, the electron beam intensity is about $1 \times 10^{20}$ e/cm$^2 \cdot$ sec, the irradiation temperature is about 20°C and the irradiation time is about 30 minutes.

4. A method according to Claim 1, wherein the foreign atoms composing the film layer (F, 2) are Au and the material forming the solid substrate (S, 1) is Si.

5. A method according to Claim 4, wherein the electron beams energy is about 2.5 MeV, the electron beam intensity is about $1 \times 10^{20}$ e/cm$^2$ sec, the irradiation temperature is about 100°C and the irradiation time is about 15 minutes.

6. A method according to Claim 1, wherein irradiation of the predetermined region with an electron beam is effected by a controllable electromagnetic field and at least one electron lens for the electron beam.

7. A method according to Claim 1, wherein intensity of the electron beam is controlled by controlling one or more of the convergence, the divergence, and the angle of incidence of the electron beam, whereby the concentration distribution of the at least one type of displaced foreign atom in the zone of mixed atoms is variable.

8. A method according to Claim 1, wherein the electron beam has an energy which is greater than the threshold energy for at least one type of atom of the solid substrate whereby solid substrate atoms are also displaced.

**Patentansprüche**

1. Verfahren zur Einbringung von Fremdatomen in ein festes Substrat unter Verwendung eines Elektronenstrahles, bei dem man eine Schichtstruktur vorsieht, die aus dem festen Substrat (S, 1) und wenigstens einer auf einer Oberfläche des festen Substrates haftenden Filmschicht (F, 2) aufgebaut ist, wobei diese Filmschicht wenigstens eine einzubringende Fremdatomtype enthält, und einen vorbestimmten Bereich der Struktur mit einem auf die Filmschicht (F, 2) gerichteten Elektronenstrahl (4) bestrahlt, um die beabsichtigte Verschiebung der wenigstens einen Fremdatomtype von der Filmschicht (F, 2) in das feste Substrat (S, 1) ohne thermische Diffusion zu bewirken und so eine Zone gemischter Atome in dem Bestrahlungsbereich zu bekommen, wobei diese Zone gemischter Atome eine Konzentration der wenigstens einen der verschobenen Fremdatomtype hat, die bis zur Übersättigung reicht und die unabhängig von dem thermischen Gleichgewichtszustand ist und wobei der Elektronenstrahl eine Energie besitzt, die größer als die Schwellenenergie für jene wenigstens eine verschobene Fremdatomtype ist und wobei dieses Verfahren kein Verfahren zum Amorphmachen eines festen kristallinen Materials durch Bestrahlung mit einem Elektronenstrahl ist, dadurch gekennzeichnet, daß man auf einer Oberfläche eines amorph zu machenden kristallinen festen Materials eine Filmschicht aufbringt, die wenigstens eine in das kristalline feste Material einzubringende Fremdatomtype enthält, so daß das Material und die aufgebrachte Schicht eine Schichtstruktur bilden, und die Struktur mit einem auf die Filmschicht gerichteten Elektronenstrahl mit einer Beschleunigungsspannung von wenigstens 200 kV, mit einer Elektronenstrahl-intensität von wenigstens $1 \times 10^{18}$ e/cm$^2$/sec und bei einer Temperatur von nicht mehr als 100°C bestrahlt und dabei Fremdatome aus der Schicht verlagert und die verlagerten Fremdatome in die bestrahlten Bereiche des kristallinen festen Materials einbringt und das kristalline Material amorph macht.

2. Verfahren nach Anspruch 1, bei dem die die Filmschicht (F, 2) bildenden Fremdatome Pd sind und das das feste Substrat (S, 1) bildende Material Si ist.

3. Verfahren nach Anspruch 2, bei dem die Elektronenstrahlenergie etwa 2,4 MeV beträgt, die Elektronenstrahlintensität etwa $1 \times 10^{20}$ e/cm$^2$/sec ist, die Bestrahlungstemperatur bei etwa 20°C liegt und die Bestrahlungszeit etwa 30 min beträgt.

4. Verfahren nach Anspruch 1, bei dem die die Filmschicht (F, 2) bildenden Fremdatome Au sind und das das feste Substrat (S, 1) bildende Material Si ist.

5. Verfahren nach Anspruch 4, bei dem die Elektronenstrahlenergie etwa 2,5 MeV beträgt, die Elektronenstrahlintensität etwa $1 \times 10^{20}$ e/cm$^2$/sec ist, die Bestrahlungstemperatur bei etwa 100°C liegt und die Bestrahlungszeit etwa 15 min beträgt.

6. Verfahren nach Anspruch 1, bei dem die Bestrahlung des vorbestimmten Bereiches mit einem Elektronenstrahl durch ein steuerbares elektromagnetisches Feld und wenigstens eine Elektronenlinse für den Elektronenstrahl bewirkt wird.

7. Verfahren nach Anspruch 1, bei dem die Intensität des Elektronenstrahls durch Steuerung eines oder mehrerer der Faktoren der Kovergenz, der Divergenz und des Einfallwinkels des Elektronenstrahles gesteuert wird, wobei die Konzentrationsverteilung der wenigstens einen verlagerten Fremdatomtype in der Zone gemischter Atome variabel ist.

8. Verfahren nach Anspruch 1, bei dem der Elektronenstrahl eine Energie hat, die größer als die Schwellenenergie für wenigstens eine Atomtype des festen Substrates ist, wobei Atome des festen Substrates auch verlagert werden.

**Revendications**

1. Procédé d'injection d'impuretés dans un substrat solide au moyen d'un faisceau électronique, ledit procédé comprenant la création d'une structure en couches constituée du substrat solide (S, 1) et d'au moins une couche mince (F, 2) collée à une surface dudit substrat solide, laquelle couche mince contient au moins un type d'impureté devant être injectée, et par l'irradiation d'une région prédéterminée de la structure avec un faisceau électronique (4) dirigé vers le couche mince (F, 2) afin d'amener un déplacement recherché dudit au moins un type d'impureté depuis la couche mince (F, 2) dans le substrat solide (S, 1) sans diffusion thermique afin de créer une zone d'atomes mixtes dans la région irradiée, ladite zone d'atomes mixtes ayant une concentration dudit au moins un type d'impureté déplacée qui s'étend à la sur saturation et qui est indépendante de l'état d'équilibre thermique, et ledit faisceau électronique ayant une énergie qui est supérieure à l'énergie de seuil pour ce au moins un type d'impureté déplacée, ce procédé n'étant pas un procédé constituant à rendre amorphe un matériaux cristallin solide par irradiation par faisceau électronique, caractérisé par la fixation à une surface d'un matériau cristallin solide devant être rendu amorphe d'une couche mince contenant au moins un type d'impureté devant être injectée dans le matériau cristallin solide de façon que le matériau et la couche fixée forment une structure en couches et par l'irradiation de la structure avec un faisceau électronique dirigé vers le couche mince à une tension accélérée d'au moins 200 kV avec une intensité du faisceau électronique d'au moins $1 \times 10^{18}$ e/cm²sec et a une température ne dépassant pas 100°C, permettant de déplacer les impuretés depuis la couche et d'injecter les impuretés déplacées dans les régions irradiées du matériau solide cristallin et de rendre le matériau cristallin amorphe.

2. Procédé selon la revendication 1, dans lequel les impuretés composant la couche mince (F, 2) sont Pd et dans lequel le matériau formant le substrat solide (S, 1) est Si.

3. Procédé selon la revendication 2, dans lequel l'énergie du faisceau électronique est d'environ 2,4 MeV l'intensité du faisceau électronique est d'environ $1 \times 10^{20}$ e/cm² sec, la température d'irradiation est d'environ 20°C et le temps d'irradiation est d'environ 30 minutes.

4. Procédé selon la revendication 1, dans lequel les impuretés composant la couche mince (F, 2) sont Au et dans lequel le matériau formant le substrat solide (S, 1) est Si.

5. Procédé selon la revendication 4, dans lequel l'énergie du faisceau électronique est d'environ 2,5 MeV, l'intensité du faisceau électronique et d'environ $1 \times 1020$ e/cm² sec, la température d'irradiation est d'environ 100°C et le temps d'irradiation est d'environ 15 minutes.

6. Procédé selon la revendication 1, dans lequel l'irradiation de la région prédéterminée avec un faisceau électronique est effectuée avec un champ électromagnétique contrôlable et au moins une lentille électronique pour le faisceau électronique.

7. Procédé selon la revendication 1, dans lequel l'intensité du faisceau électronique est contrôlée par le contrôle d'une ou plusieurs de la convergence, la divergence, et l'angle d'incidence du faiseau électronique, permettant que la répartition de concentration d'au moins un type d'impureté déplacée dans la zone d'atomes mixtes soit variable.

8. Procédé selon la revendication 1, dans lequel le faisceau électronique a une énergie qui est supérieure à l'énergie de seuil pour un type d'atome du substrat solide permettant que les atomes du substrat solide soient également déplacés.

EP 0 192 874 B1

# FIG.1a

# FIG.1b

# FIG.2